# EUROPEAN PATENT APPLICATION

(11) **EP 3 041 054 A1**
(43) Date of publication of application: **06.07.2016**
(21) Application number: 15200428.9
(22) Date of filing: 16.12.2015
(51) Int. Cl.: H01L 29/786

(54) **THIN FILM TRANSISTOR AND DISPLAY DEVICE INCLUDING THE SAME**

(30) Priority: 31.12.2014 KR 20140195693
(71) Applicant: Samsung Display Co., Ltd., Gyeonggi-do 17113 (KR)
(72) Inventor: YANG, Shin-Hyuk, Gyeonggi-Do (KR); KIM, Eun-Hyun, Gyeonggi-Do (KR); KIM, Tae-Young, Gyeonggi-Do (KR)
(74) Representative: Taor, Simon Edward William

(57) **Abstract**

A thin film transistor including a gate electrode disposed on a substrate, a channel overlapping the gate electrode, a source electrode electrically connected to the channel, and a drain electrode electrically connected to the channel and spaced apart from the source electrode. The channel includes a first channel layer contacting the source electrode and the drain electrode, and a second channel layer disposed on the first channel layer and spaced apart from the source electrode and the drain electrode

## Description

Exemplary embodiments relate to a thin film transistor. More particularly, exemplary embodiments relate to a thin film transistor and a display device including a thin film transistor.

A substrate including a thin film transistor may be used for driving a pixel of a display device such as plasma display device, a liquid crystal display device, an organic light-emitting display device, or the like.

A channel of the thin film transistor may include amorphous silicon, polysilicon, semiconductive oxide, or the like.

Because display devices have increased in size and, thereby, have also required higher resolution, a thin film transistor of the display device also has required improvements. In order to improve the thin film transistor, research has been conducted for increasing an electron mobility of the channel.

The above information disclosed in this Background section is only for enhancement of understanding of the background of the inventive concept, and, therefore, it may contain information that does not form the prior art that is already known in this country to a person of ordinary skill in the art.

Exemplary embodiments provide a thin film transistor having improved electric properties.

Exemplary embodiments provide a display device including a thin film transistor.

Additional aspects will be set forth in the detailed description which follows, and, in part, will be apparent from the disclosure, or may be learned by practice of the inventive concept.

An exemplary embodiment discloses a thin film transistor including a gate electrode disposed on a substrate, a channel overlapping the gate electrode, a source electrode electrically connected to the channel, and a drain electrode electrically connected to the channel and spaced apart from the source electrode. The channel includes a first channel layer contacting the source electrode and the drain electrode, and a second channel layer disposed on the first channel layer and spaced apart from the source electrode and the drain electrode.

An exemplary embodiment also discloses a liquid crystal display device including first and second substrates facing each other with a liquid crystal layer disposed therebetween. The first substrate includes a gate electrode, a channel overlapping the gate electrode, a source electrode electrically connected to the channel, a drain electrode electrically connected to the channel and spaced apart from the source electrode, and a pixel electrode electrically connected to the drain electrode. The channel includes a first channel layer contacting the source electrode and the drain electrode, and a second channel layer disposed on the first channel layer and spaced apart from the source electrode and the drain electrode.

An exemplary embodiment also discloses an organic light-emitting display device including a gate electrode, a channel overlapping the gate electrode, a source electrode electrically connected to the channel, a drain electrode electrically connected to the channel and spaced apart from the source electrode, a first electrode electrically connected to the drain electrode, a light-emitting layer disposed on the first electrode, and a second electrode on the light-emitting layer. The channel includes a first channel layer contacting the source electrode and the drain electrode, and a second channel layer disposed on the first channel layer and spaced apart from the source electrode and the drain electrode.

According to an aspect of the invention, there is provided a thin film transistor as set out in claim 1. Preferred features of this aspect are set out in claims 2 to 14.

According to an aspect of the invention, there is provided a display device as set out in claim 15.

The foregoing general description and the following detailed description are exemplary and explanatory and are intended to provide further explanation of the claimed subject matter.

The accompanying drawings, which are included to provide a further understanding of the inventive concept, and are incorporated in and constitute a part of this specification, illustrate exemplary embodiments of the inventive concept, and, together with the description, serve to explain principles of the inventive concept.
FIG. 1 is a cross-sectional view partially illustrating a display substrate according to an exemplary embodiment.
FIG. 2 is a cross-section view illustrating a display device according to an exemplary embodiment and taken along the line I-I' of FIG. 1.
FIG. 3 is an enlarged view illustrating the 'A' area of FIG. 1.
FIG. 4 is a cross-sectional view illustrating a display substrate according to an exemplary embodiment.
FIG. 5 is a cross-sectional view illustrating a display substrate according to an exemplary embodiment.
FIG. 6 is a cross-sectional view illustrating a display substrate according to an exemplary embodiment.
FIG. 7 is a cross-sectional view illustrating a display substrate according to an exemplary embodiment.
FIG. 8 is a cross-sectional view illustrating a display substrate according to an exemplary embodiment.
FIG. 9 is a cross-sectional view illustrating a display substrate according to an exemplary embodiment.
FIGS. 10 to 18 are cross-sectional views illustrating a method for manufacturing a display substrate according to an exemplary embodiment.

In the following description, for the purposes of explanation, numerous specific details are set forth in order to provide a thorough understanding of various exemplary embodiments. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments.

In the accompanying figures, the size and relative sizes of layers, films, panels, regions, etc., may be exaggerated for clarity and descriptive purposes. Also, like reference numerals denote like elements.

When an element or layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. Like numbers refer to like elements throughout. As used herein, the term "and/or" includes any and all combinations of one or more of the associated listed items.

Although the terms first, second, etc. may be used herein to describe various elements, components, regions, layers, and/or sections, these elements, components, regions, layers, and/or sections should not be limited by these terms. These terms are used to distinguish one element, component, region, layer, and/or section from another element, component, region, layer, and/or section. Thus, a first element, component, region, layer, and/or section discussed below could be termed a second element, component, region, layer, and/or section without departing from the teachings of the present disclosure.

Spatially relative terms, such as "beneath," "below," "lower," "above," "upper," and the like, may be used herein for descriptive purposes, and, thereby, to describe one element or feature's relationship to another element(s) or feature(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

Various exemplary embodiments are described herein with reference to sectional illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not be construed as limited to the particular illustrated shapes of regions, but are to include deviations in shapes that result from, for instance, manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and will not be interpreted in an idealized or overly formal sense, unless expressly so defined herein.

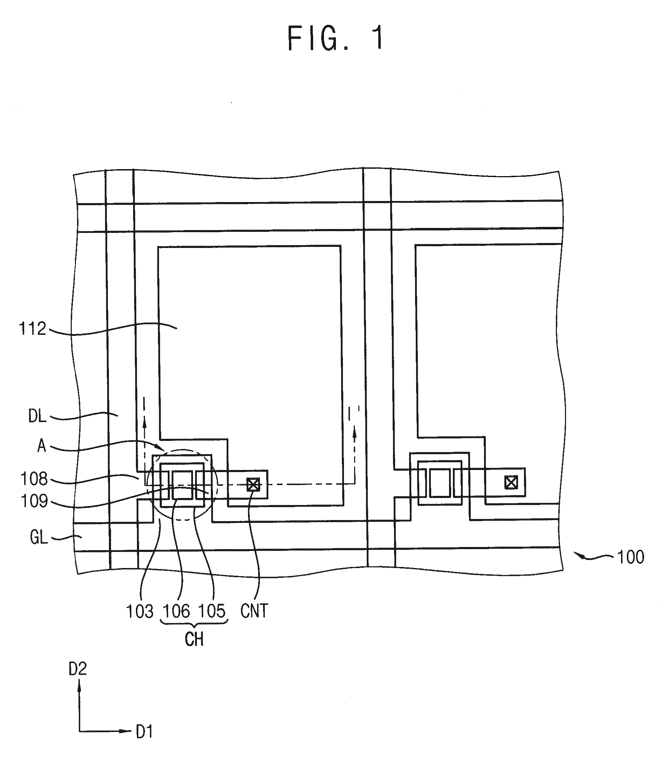

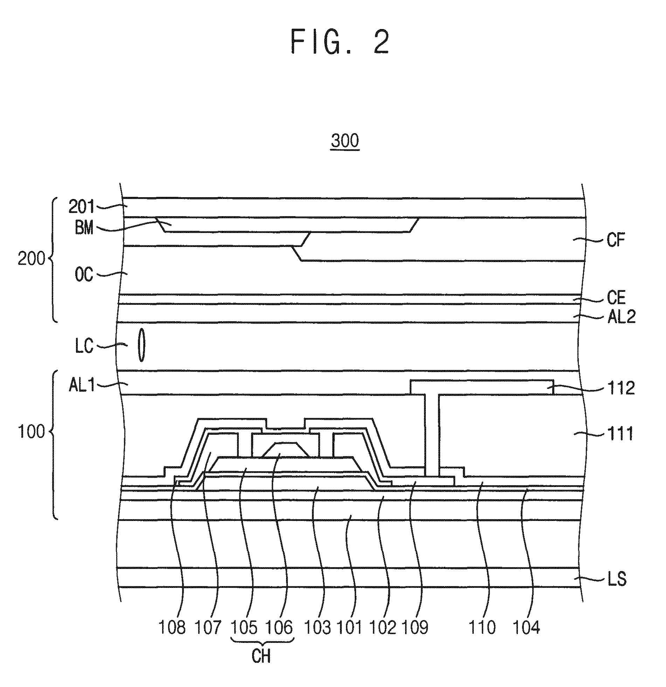

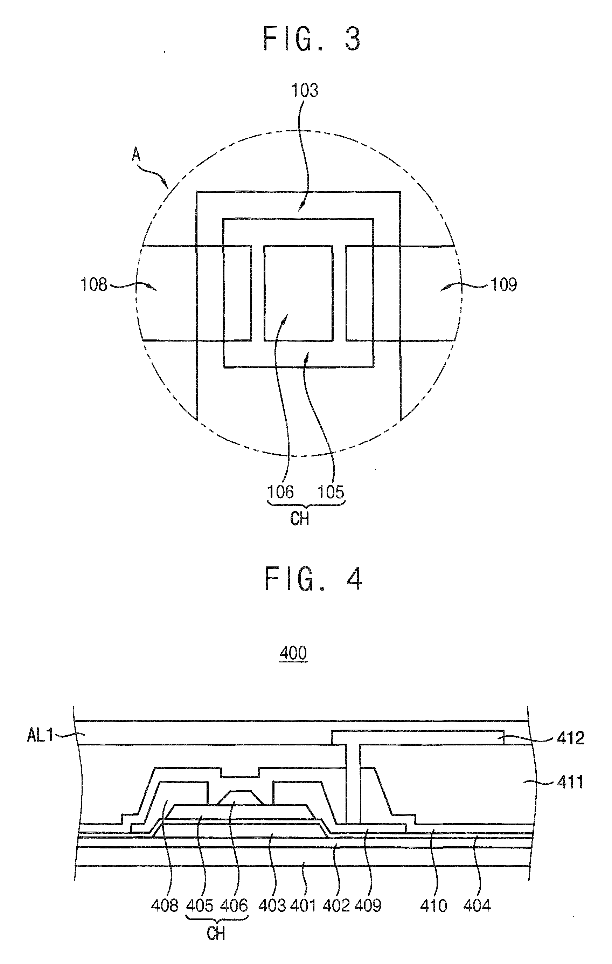

FIG. 1 is a cross-sectional view partially illustrating a display substrate according to an exemplary embodiment. FIG. 2 is a cross-section view illustrating a display device according to an exemplary embodiment and taken along the line I-I' of FIG. 1. FIG. 3 is an enlarged view illustrating the 'A' area of FIG. 1.

Referring to FIGS. 1 to 3, a display device 300 may include a first display substrate 100, a liquid crystal layer LC, and a second display substrate 200.

The first display substrate 100 may include a first insulation substrate 101, a buffer layer 102, a gate line GL, a data line DL, a gate electrode 103, a channel layer CH, a first insulation layer 104, an etch-stop layer 107, a source electrode 108, a drain electrode 109, a second insulation layer 110, a third insulation layer 111, and a pixel electrode 112.

The first insulation substrate 101 may include glass, quartz, flexible plastic, or the like. A plastic substrate may include a polymer having a high heat resistance so that processes for forming a thin film transistor may be stably performed thereon. For example, the first insulation substrate 101 may include polyethylene terephthalate, polyethylene naphthalate, polyether ether ketone, or the like. Furthermore, the first insulation substrate 101 may include polycarbonate, polyarylate, polyether sulfone, polyimide, or the like to provide increased heat resistance.

The gate line GL extends in a first direction D1. The gate electrode 103 is electrically connected to the gate line GL. The gate electrode 103 may be formed from the same layer as the gate line GL or from a layer other than the gate line GL. In an exemplary embodiment, the gate electrode 103 may protrude from the gate line GL. In another exemplary embodiment, the gate electrode 103 does not protrude from the gate line GL, and a portion of the gate line GL may overlap the channel layer CH to function as a gate electrode.

The gate electrode 103 receives a gate signal through the gate line GL. The channel layer CH is turned on or off by the gate signal.

The data line DL extends in a second direction D2 different from the first direction D1. The first direction D1 may be substantially perpendicular to the second direction D2.

In an exemplary embodiment, the source electrode 108 may protrude from the data line DL. In another exemplary embodiment, the source electrode 108 does not protrude from the data line DL, and a portion of the data line DL may function as a source electrode.

The source electrode 108 receives a data signal through the data line DL. The data signal may apply a pixel voltage to the pixel electrode 112 through the channel layer CH and the drain electrode 109.

The gate electrode 103 may include aluminum, silver, copper, molybdenum, chromium, manganese, an alloy thereof, or a combination thereof.

The gate electrode 103 may have a single-layered structure or a multiple-layered structure including different metal layers. For example, the gate electrode 103 may have a double-layered structure or a triple-layered structure. For example, the gate electrode 103 may have a double-layered structure of copper/titanium or a triple-layered structure of aluminum/molybdenum/aluminum. Furthermore, the gate electrode 103 may include a metal layer and a metal oxide layer.

The buffer layer 102 may be disposed between the first insulation substrate 101 and the gate electrode 103 to prevent humidity or impurities from penetrating into the first insulation substrate 101 and to flatten a surface of the first insulation substrate 101. The buffer layer 102 may be disposed partially or entirely on an upper surface of the first insulation substrate 101.

The buffer layer 102 may include silicon oxide (SiOₓ) or silicon nitride (SiNₓ), and may be formed through various methods including chemical vapor deposition (CVD). The buffer layer 102 may have a single-layered structure or a multiple-layered structure including different layers.

The first insulation layer 104 may be disposed on the gate electrode 103. The first insulation layer 104 may include an insulation material, such as silicon oxide or silicon nitride. The first insulation layer 104 may be disposed partially or entirely on the first insulation substrate 101. The first insulation layer 104 may have a single-layered structure or a multiple-layered structure including different layers. For example, the first insulation layer 104 may have a double-layered structure or a triple-layered structure. For example, the first insulation layer 104 may have a double-layered structure of silicon oxide/silicon nitride, or a triple-layered structure of silicon nitride/silicon oxide/silicon nitride.

The channel layer CH may be disposed on the first insulation layer 104. The channel layer CH overlaps the gate electrode 103.

In an exemplary embodiment, the channel layer CH, which may be also referred to as a channel, may include a first channel layer 105 and a second channel layer 106.

The second channel layer 106 may be disposed on the first channel layer 105. Thus, a lower surface of the second channel layer 106 may contact the first channel layer 105.

In a plan view, a size of the second channel layer 106 may be less than a size of the first channel layer 105. For example, a length of the second channel layer 106 along the second direction D2 may be less than a length of the first channel layer 105 along the second direction D2. Furthermore, a length of the second channel layer 106 along the first direction D1 may be less than a length of the first channel layer 105 along the first direction D1.

In a plan view of an exemplary embodiment, an area of the second channel layer 106 may be less than an area of the first channel layer 105. In a plan view of an exemplary embodiment, an outer line of the second channel layer 106 is entirely spaced apart from an outer line of the first channel layer 105. Thus, a plan view shows that the first channel layer 105 may surround the second channel layer 106. In other words, when considered in a plan view (or in a direction normal to the substrate), the first channel layer 105 may surround the second channel layer 106. Hence, the second channel layer 106 may be considered to be in the form of an island shape on the first channel layer 105.

A lower surface of the second channel layer 106 may be entirely covered by an upper surface of the first channel layer 105. The upper and lower surfaces of the first channel layer 105 may be considered to be the surfaces that are parallel to the plane of the substrate, with the upper surface being a surface that faces away from the substrate, and the lower surface being a surface that faces towards the substrate. "Lower" and "upper" in this context referring to surfaces that are nearer or further from the substrate.

The channel layer CH may have a thickness of about 55nm to about 100nm. A thickness of the first channel layer 105 may be in a range of about 25nm to about 50nm, and a thickness of the second channel layer 106 may be in a range of about 30nm to about 50nm. The thickness of the channel layer CH may vary depending on a structure or a type of a display device including the channel layer CH. For example, in a liquid crystal display device, the thickness of the first channel layer 105 may be in a range of about 25nm to about 35nm, and the thickness of the second channel layer 106 may be in a range of about 30nm to about 50nm. In an organic light-emitting display device, the thickness of the first channel layer 105 may be in a range of about 35nm to about 50nm, and the thickness of the second channel layer 106 may be substantially same as the first channel layer 105.

As illustrated in FIG. 2, a cross-section of the channel layer CH may have a substantially tapered shape. For example, a width of an upper end may be less than a width of a lower end in the channel layer CH. In other words, the side surfaces of the first channel layer 105 and the second channel layer 106 (e.g. the surfaces that are not parallel to the plane of the substrate) may be tapered.

The first channel layer 105 and the second channel layer 106 may have different taper angles. For example, a taper angle of the second channel layer 106 may be less than a taper angle of the first channel layer 105. The taper angle may be defined as an angle formed by a side surface and a lower surface of each of the channel layers.

When the taper angle of the second channel layer 106 is less than the taper angle of the first channel layer 105, the number of disconnection defects may be reduced in a process for forming layers on the channel layer CH. In another exemplary embodiment, the first channel layer 105 and the second channel layer 106 may have a substantially same taper angle depending on a material or process conditions for the channel layer CH.

The channel layer CH may include an oxide. For example, the channel layer CH may include an oxide based on aluminum, gallium, indium, zinc, tin, hafnium, or zirconium, or a combination thererof. For example, the channel layer CH may include aluminum zinc oxide (AZO), indium zinc tin oxide (IZTO), aluminum zinc tin oxide (AZTO), or the like.

In an exemplary embodiment, the first channel layer 105 and the second channel layer 106 may include different oxides.

For example, the first channel layer 105 may include at least one of tin and aluminum.

The first channel layer 105 including tin or aluminum may have an etching resistance higher than the second channel layer 106. For example, when an amount of aluminum in the first channel layer 105 is increased, an etching resistance may be increased. Thus, the first channel layer 105 and the second channel layer 106 may be formed through the same etching process. The second channel layer 106 may include a material having an etching resistance lower than the first channel layer 105. For example, the second channel layer 106 may include an oxide based on indium or zinc. For example, the second channel layer 106 may include indium zinc oxide (IZO), aluminum zinc oxide (AZO), or the like. When the first channel layer 105 and the second channel layer 106 includes aluminum, the amount of aluminum of the first channel layer 105 may be greater than the amount of aluminum of the second channel layer 106.

A carrier concentration of the second channel layer 106 may be greater than a carrier concentration of the first channel layer 105. For example, the carrier concentration of the first channel layer 105 may be about 10¹⁶cm³ to about 10¹⁸ cm³ and the carrier concentration of the second channel layer 106 may be about 10¹⁸ cm³ to about 10²¹ cm³. The carrier concentration of the second channel layer 106 may be about 10¹⁹ cm³ to about 10²⁰ cm³.

When the carrier concentration of the second channel layer 106 is greater than a carrier concentration of the first channel layer 105, an area in which an electron mobility is high is formed in the channel layer CH. Thus, a current level of the thin film transistor is increased. Thus, display quality of a display device may be improved.

The etch-stop layer 107 may be disposed on the channel layer CH.

The etch-stop layer 107 may include an insulation material such as silicon oxide, silicon nitride, or the like.

The etch-stop layer 107 may cover the channel layer CH and the first insulation layer 104. The etch-stop layer 107 may partially cover the channel layer CH. A portion of the channel layer CH, which is uncovered by the etch-stop layer 107, may contact the source electrode 108 and the drain electrode 109. For example, the second channel layer 106 may be entirely covered by the etch-stop layer 107, and a portion of the first channel layer 106 may contact the source electrode 108 and the drain electrode 109 (e.g. through a via hole or otherwise through the etch-stop layer 107). The etch-stop layer 107 may protect the channel layer CH in the process of forming the source electrode 108 and the drain electrode 109.

The source electrode 108 and the drain electrode 109 may be disposed on the etch-stop layer 107. In other words, in some embodiments, a portion of the source electrode 108 and the drain electrode 109 may be disposed on the etch-stop layer 107, with a portion of the source electrode 108 and the drain electrode 109 contacting the first channel layer 106 (e.g. through a via hole or otherwise through the etch-stop layer 107).

The source electrode 108 may overlap the channel layer CH. The source electrode 108 may contact the first channel layer 105 and may be spaced apart from the second channel layer 106.

The drain electrode 109 may overlap the channel layer CH. The drain electrode 109 may contact the first channel layer 105 and may be spaced apart from the second channel layer 106.

When the source electrode 108 or the drain electrode 109 contacts the second channel layer 106 having a greater carrier concentration, a short circuit may be generated, thereby deteriorating the thin film transistor.

The second insulation layer 110 may be disposed on the source electrode 108 and the drain electrode 109.

The second insulation layer 110 may include an inorganic material or an organic material. For example, the second insulation layer 110 may include silicon oxide, silicon nitride, acryl resin, or the like.

The second insulation layer 110 may partially cover the drain electrode 109. A portion of the drain electrode 109, which is uncovered by the second insulation layer 110, may contact the pixel electrode 112.

The third insulation layer 111 may be disposed between the second insulation layer 110 and the pixel electrode 112.

The third insulation layer 111 may include an inorganic material or an organic material, and may have a substantially flat upper surface. For example, the third insulation layer 111 may include silicon oxide, silicon nitride, a polymer resin, such as acryl resin, or the like.

The pixel electrode 112 contacts the drain electrode 109 and may be disposed on the third insulation layer 111.

The pixel electrode 112 may include a transparent conductive material. For example, the pixel electrode 112 may include indium tin oxide, indium zinc oxide, indium gallium oxide, tin oxide, zinc oxide, or the like.

The first alignment layer AL1 may be disposed on the pixel electrode 112. The first alignment layer AL1 aligns adjacent liquid crystal molecules in a direction. The first alignment layer AL1 may include a polymer such as polyimide, silicone resin, or the like.

The second display substrate 200 may include a second insulation substrate 201, a light-blocking layer BM, a color filter CF, a common electrode CE, and a second alignment layer AL2.

The second insulation substrate 201 may include substantially the same material as the first insulation substrate 101.

The light-blocking layer BM is disposed on the second insulation substrate 201, for example, on a lower surface of the second insulation substrate 201. In general, the light-blocking layer BM may be disposed in a region appropriate for blocking light leakage. For example, the light-blocking layer BM may overlap at least one of the data line DL, the gate line GL, and the thin film transistor to block a light.

The light-blocking layer BM may include carbon black, or a mixture of a red pigment, a blue pigment, and a green pigment.

The color filter CF may be disposed on the second insulation substrate 201, for example, on a lower surface of the second insulation substrate 201. The color filter CF may partially overlap the light-blocking layer BM. The color filter CF provides a color to a light generated by the light source module LS and passing through the liquid crystal layer LC. The color filter CF may include a red color filter, a green color filter, a blue color filter, a yellow color filter, or the like. The color filter CF may overlap the pixel electrode 112. Color filters having different colors may be disposed to each other. In an exemplary embodiment, color filters adjacent to each other may overlap each other, and an overlapped portion of the color filters may overlap the light-blocking layer BM. In another exemplary embodiment, color filters adjacent to each other may be spaced apart from each other.

The color filter CF may include a red pigment, a blue pigment, a green pigment, a yellow pigment, or a dye.

The common electrode CE may be disposed to cover the color filter CF. The common electrode CE may be disposed entirely or partially on the second insulation substrate 201.

The common electrode CE may include a transparent conductive material. For example, the common electrode CE may include indium tin oxide, indium zinc oxide, indium gallium oxide, tin oxide, zinc oxide, or the like.

In an exemplary embodiment, the second substrate 200 includes the light-blocking layer BM and the color filter CF. However, at least one of the light-blocking layer BM and the color filter CF may be included in the first substrate 100 in another exemplary embodiment.

The second alignment layer AL2 may be disposed to cover a surface of the common electrode CE. The second alignment layer AL2 aligns adjacent liquid crystal molecules in a specific direction. The second alignment layer AL2 may include a polymer, such as polyimide, silicone resin, or the like. While the second alignment layer AL2 may include a same material as the first alignment layer AL1, the second alignment layer AL2 may include an another material different from the first alignment layer AL1 for adjusting alignment.

The liquid crystal layer LC may be disposed between the first insulation substrate 101 and the second insulation substrate 201. The liquid crystal layer LC may include a liquid crystal molecule having an optical anisotropy. The liquid crystal layer LC may change transmittance of a light passing therethrough in response to a voltage applied thereto.

The light source module LS may be disposed under the first insulation layer 101. The light source module LS provides a light to the display panel. The light source module LS may be a backlight assembly, including a direct-type backlight assembly or an edge-type backlight assembly.

FIG. 4 is a cross-sectional view illustrating a display substrate according to an exemplary embodiment.

Referring to FIG. 4, a display substrate 400 includes an insulation substrate 401, a buffer layer 402, a gate electrode 403, a first insulation layer 404, a source electrode 408, a drain electrode 409, a channel layer CH, a second insulation layer 410, a third insulation layer 411, a pixel electrode 412, and an alignment layer AL1. The display substrate 400 is substantially the same as the first substrate 100 illustrated in FIG. 2, except for the omission of an etch-stop layer. Thus, any duplicated explanation may be omitted.

The channel layer CH may include a first channel layer 405 and a second channel layer 406.

A carrier concentration of the second channel layer 406 may be greater than a carrier concentration of the first channel layer 405. When the carrier concentration of the second channel layer 406 is greater than a carrier concentration of the first channel layer 405, an area in which an electron mobility is high is formed in the channel layer CH. Thus, a current level of the thin film transistor may be increased. Thus, display quality of a display device may be improved.

The source electrode 408 and the drain electrode 409 may be disposed on the channel layer CH. The source electrode 408 may overlap the channel layer CH. The source electrode 408 may contact the first channel layer 405 and may be spaced apart from the second channel layer 406.

The drain electrode 409 may be spaced apart from the source electrode 408. The drain electrode 409 may contact the first channel layer 405 and may be spaced apart from the second channel layer 406. Because the display substrate does not include an etch-stop layer, the source electrode 408 and the drain electrode 409 may cover at least a portion of an upper surface and at least a portion of a side surface of the first channel layer 405.

The second insulation layer 410 may be disposed on the source electrode 408 and the drain electrode 409. The second insulation layer 410 may include an inorganic material or an organic material. For example, the second insulation layer 410 may include silicon oxide, silicon nitride, acryl resin, or the like.

The second insulation layer 410 may partially cover the drain electrode 409. A portion of the drain electrode 409, which is uncovered by the second insulation layer 410, may contact the pixel electrode 412. The third insulation layer 411 may be disposed on the second insulation layer 410. The pixel electrode 412 may contact the drain electrode 409 through a contact hole formed through the third insulation layer 411.

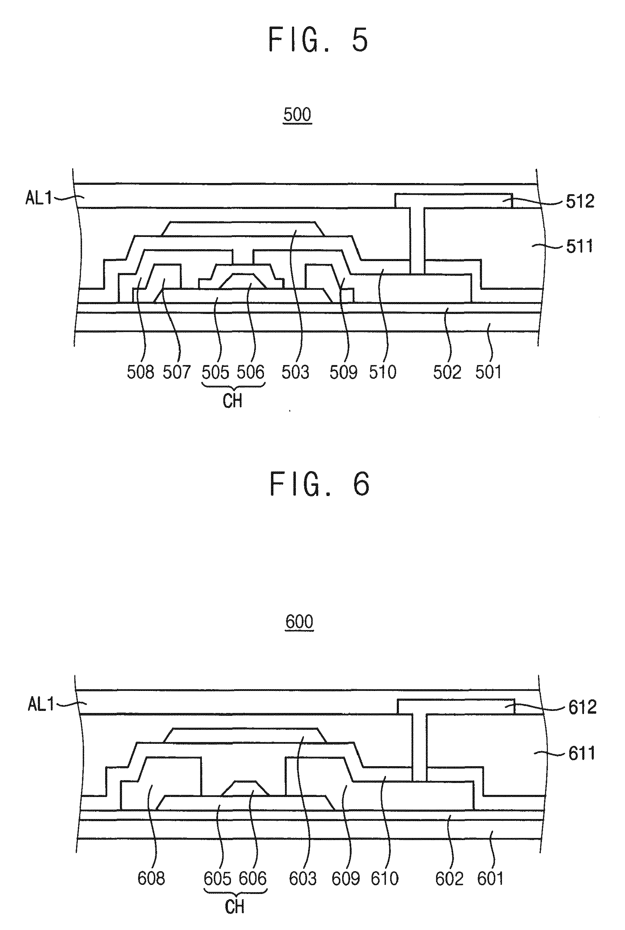

FIG. 5 is a cross-sectional view illustrating a display substrate according to an exemplary embodiment.

Referring to FIG. 5, a display substrate 500 includes an insulation substrate 501, a buffer layer 502, a channel layer CH, an etch-stop layer 507, a source electrode 508, a drain electrode 509, a first insulation layer 510, a gate electrode 503, a second insulation layer 511, a pixel electrode 512, and an alignment layer AL1.

The display substrate 500 is substantially the same as the first substrate 100 illustrated in FIG. 2 except for the position of the gate electrode 503. Thus, any duplicated explanation may be omitted.

The channel layer CH may be disposed on the insulation substrate 501.

The channel layer CH may include a first channel layer 505 and a second channel layer 506.

A carrier concentration of the second channel layer 506 may be greater than a carrier concentration of the first channel layer 505. When the carrier concentration of the second channel layer 506 is greater than a carrier concentration of the first channel layer 505, an area in which an electron mobility is high is formed in the channel layer CH. Thus, a current level of the thin film transistor may be increased, thereby improving a display quality of a display device.

The etch-stop layer 507 may be disposed on the channel layer CH.

The etch-stop layer 507 may partially cover the channel layer CH. A portion of the channel layer CH, which is uncovered by the etch-stop layer 507, may contact the source electrode 508 and the drain electrode 509. For example, the second channel layer 506 may be entirely covered by the etch-stop layer 507, and a portion of the first channel layer 505 may contact the source electrode 508 and the drain electrode 509. The etch-stop layer 507 may protect the channel layer CH in the process of forming the source electrode 508 and the drain electrode 509.

The source electrode 508 and the drain electrode 509 may be disposed on the etch-stop layer 507. In other words, in some embodiments, a portion of the source electrode 508 and the drain electrode 509 may be disposed on the etch-stop layer 507, with a portion of the source electrode 508 and the drain electrode 509 contacting the channel layer CH.

The source electrode 508 may overlap the channel layer CH. The source electrode 508 may contact the first channel layer 505 and may be spaced apart from the second channel layer 506.

The drain electrode 509 may be spaced apart from the source electrode 508. The drain electrode 509 may contact the first channel layer 505 and may be spaced apart from the second channel layer 506.

When the source electrode 508 or the drain electrode 509 contacts the second channel layer 506 having a greater carrier concentration, a short-circuit may be generated, causing deterioration of the thin film transistor.

The first insulation layer 510 may be disposed on the source electrode 508 and the drain electrode 509.

The first insulation layer 510 may partially cover the drain electrode 509. A portion of the drain electrode 509, which is uncovered by the first insulation layer 510, may contact the pixel electrode 512.

The gate electrode 503 may be disposed on the first insulation layer 510. The gate electrode 503 may overlap the channel layer CH.

The second insulation layer 511 may be disposed on the gate electrode 503. The pixel electrode 512 may contact the drain electrode 509 though a contact hole formed through the second insulation layer 511.

FIG. 6 is a cross-sectional view illustrating a display substrate according to an exemplary embodiment.

Referring to FIG. 6, a display substrate 600 includes an insulation substrate 601, a buffer layer 602, a channel layer CH, a source electrode 608, a drain electrode 609, a first insulation layer 610, a gate electrode 603, a second insulation layer 611, a pixel electrode 612, and an alignment layer AL1.

The display substrate 600 is substantially the same as the first substrate 500 illustrated in FIG. 5 except for the omission of the etch-stop layer. Thus, any duplicated explanation may be omitted.

The channel layer CH may be disposed on the insulation substrate 601.

The channel layer CH may include a first channel layer 605 and a second channel layer 606.

A carrier concentration of the second channel layer 606 may be greater than a carrier concentration of the first channel layer 605. When the carrier concentration of the second channel layer 606 is greater than a carrier concentration of the first channel layer 605, an area in which an electron mobility is high is formed in the channel layer CH. Thus, a current level of the thin film transistor may be increased, resulting in an improvement in the display quality of a display device.

The source electrode 608 and the drain electrode 609 may be disposed on the channel layer CH.

The source electrode 608 may overlap the channel layer CH. The source electrode 608 may contact the first channel layer 605 and may be spaced apart from the second channel layer 606.

The drain electrode 609 may be spaced apart from the source electrode 608. The drain electrode 609 may contact the first channel layer 605 and may be spaced apart from the second channel layer 606.

When the source electrode 608 or the drain electrode 609 contacts the second channel layer 606 having a greater carrier concentration, a short-circuit may be generated, resulting in deterioration of the thin film transistor.

The first insulation layer 610 may be disposed on the source electrode 608 and the drain electrode 609.

The first insulation layer 610 may partially cover the drain electrode 609. A portion of the drain electrode 609, which is uncovered by the first insulation layer 610, may contact the pixel electrode 612.

The gate electrode 603 may be disposed on the first insulation layer 610. The gate electrode 603 may overlap the channel layer CH.

The second insulation layer 611 may be disposed on the gate electrode 603. The pixel electrode 612 may contact the drain electrode 609 though a contact hole formed through the second insulation layer 611.

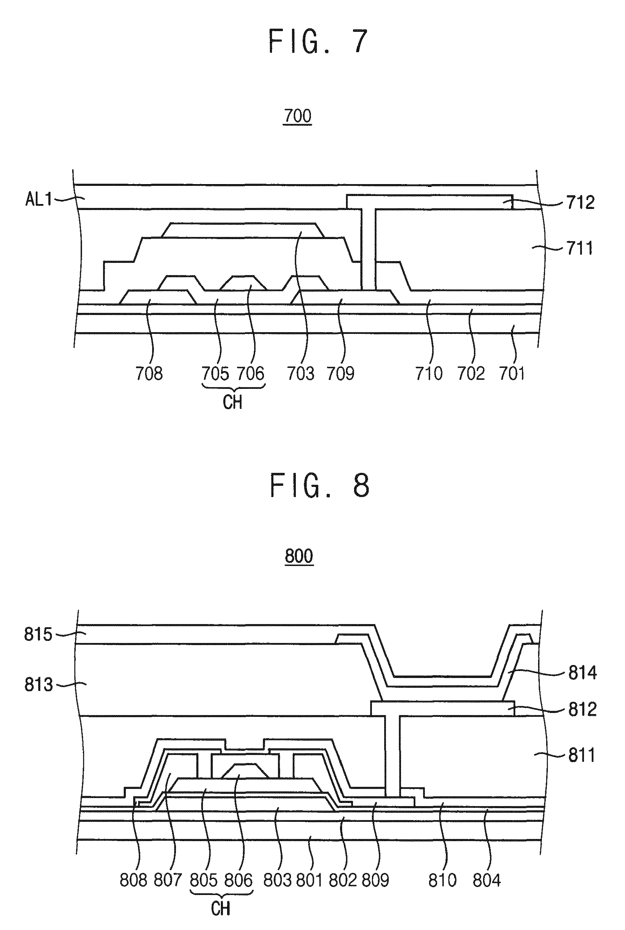

FIG. 7 is a cross-sectional view illustrating a display substrate according to an exemplary embodiment.

Referring to FIG. 7, a display substrate 700 includes an insulation substrate 701, a buffer layer 702, a source electrode 708, a drain electrode 709, a channel layer CH, a first insulation layer 710, a gate electrode 703, a second insulation layer 711, a pixel electrode 712, and an alignment layer AL1.

The source electrode 708 and the drain electrode 709 may be disposed on the insulation substrate 701. The drain electrode 709 may be spaced apart from the source electrode 708.

The channel layer CH may be disposed on the insulation substrate 701.

The channel layer CH may include a first channel layer 705 and a second channel layer 706.

A carrier concentration of the second channel layer 706 may be greater than a carrier concentration of the first channel layer 705. When the carrier concentration of the second channel layer 706 is greater than a carrier concentration of the first channel layer 705, an area in which an electron mobility is high is formed in the channel layer CH. Thus, a current level of the thin film transistor may be increased, resulting in an improvement in the display quality of a display device.

The source electrode 708 may overlap the channel layer CH. The source electrode 708 may contact the first channel layer 705 and may be spaced apart from the second channel layer 706. The first channel layer 705 may cover at least a portion of an upper surface of the source electrode 708.

The drain electrode 709 may be spaced apart from the source electrode 708. The drain electrode 709 may contact the first channel layer 705 and may be spaced apart from the second channel layer 706. The first channel layer 705 may cover at least a portion of an upper surface of the drain electrode 709.

When the source electrode 708 or the drain electrode 709 contacts the second channel layer 706 having a greater carrier concentration, a short-circuit may be generated resulting in deterioration of the thin film transistor.

The first insulation layer 710 may be disposed on the source electrode 708 and the drain electrode 709.

The first insulation layer 710 may partially cover the drain electrode 709. A portion of the drain electrode 709, which is uncovered by the first insulation layer 710, may contact the pixel electrode 712.

The gate electrode 703 may be disposed on the first insulation layer 710. The gate electrode 703 may overlap the channel layer CH.

The second insulation layer 711 may be disposed on the gate electrode 703. The pixel electrode 712 may contact the drain electrode 709 though a contact hole formed through the second insulation layer 711.

FIG. 8 is a cross-sectional view illustrating a display substrate according to an exemplary embodiment.

Referring to FIG. 8, a display substrate 800 includes an insulation substrate 801, a buffer layer 802, a gate electrode 803, a first insulation layer 804, a channel layer CH, an etch-stop layer 807, a source electrode 808, a drain electrode 809, a second insulation layer 810, a third insulation layer 811, a first electrode 812, a partition wall 813, a light-emitting layer 814, and a second electrode 815.

The display substrate 800 is substantially the same as the first substrate 100 illustrated in FIG. 2 except for further including the partition wall 813, the light-emitting layer 814, and the second electrode 815, while omitting the alignment layer AL1. Thus, any duplicated explanation may be omitted.

The channel layer CH may be disposed on the insulation substrate 801.

The channel layer CH may include a first channel layer 805 and a second channel layer 806.

A carrier concentration of the second channel layer 806 may be greater than a carrier concentration of the first channel layer 805. When the carrier concentration of the second channel layer 806 is greater than a carrier concentration of the first channel layer 805, an area in which an electron mobility is high is formed in the channel layer CH. Thus, a current level of the thin film transistor may be increased, resulting in an improvement in the display quality of a display device.

The partition wall 813 may be disposed on the third insulation layer 811. The partition wall 813 may include an organic material or an inorganic material. For example, the partition wall 813 may include polyacryl resin, polyimide resin, phenol resin, silicone resin, or the like.

In this exemplary embodiment, the partition wall 813 may partially overlap the first electrode 812, but in other exemplary embodiments the partition wall 813 may not overlap the first electrode 812.

The light-emitting layer 814 may be disposed on the first electrode 812. The light-emitting layer 814 may or may not overlap the partition wall 813. While the light-emitting layer 814 partially overlaps the partition wall 813 in an exemplary embodiment, the light-emitting layer 814 may entirely cover the partition wall 813 in other exemplary embodiments.

The light-emitting layer 814 may include a single layered structure or a multiple layered structure including at least one of a hole-injection layer, a hole-transfer layer, an organic light-emitting layer, an electron-transfer layer, and an electro-injection layer.

For example, the light-emitting layer 814 may include copper phthalocyanine, N,N'-diphenylbenzidine, tris-(8-hydroxyquinoline)aluminum, poly(3,4-ethylenedioxy)thiophene, polyaniline, poly-phenylenevinylene, polyfluorene, or the like.

The light-emitting layer 814 may include a low molecular weight organic compound or a high molecular weight organic compound, which is capable of emitting at least one of a red light, a blue light, and a green light. In another exemplary embodiment, the light-emitting layer 814 may have a multiple-layered structure including a red light-emitting layer, a green light-emitting layer, and a blue light-emitting layer, or a single-layered structure including a red light-emitting material, a green light-emitting material and a blue light-emitting material, in order to emit a white light.

An organic layer of the light-emitting layer 814 may be formed through a vacuum deposition method.

The second electrode 815 may be disposed on the light-emitting layer 814. The second electrode 815 may cover the partition wall 813 and the light-emitting layer 814. The first electrode 812 may function as an anode, and the second electrode 815 may function as a cathode. In another exemplary embodiment, the first electrode 812 may function as the cathode, and the second electrode 815 may function as the anode.

The first electrode 812 and the second electrode 815 may include a transparent material or a reflective material according to a light-emitting type of the display substrate 800. The display substrate 800 may emit a light through a front surface or a rear surface. For example, the first electrode 812 including a transparent material may include indium tin oxide, indium zinc oxide, zinc tin oxide, zinc oxide, tin oxide, or the like. For example, the first electrode 812 including a reflective material may include gold, silver, aluminum, platinum, magnesium, chromium, tungsten, molybdenum, titanium, a compound thereof, or the like, further to the transparent material. Furthermore, the second electrode 815 may include the transparent material and the reflective material. For example, the second electrode 815 may include lithium, calcium, lithium fluoride/calcium, lithium fluoride/aluminum, aluminum, magnesium, silver, chromium, tungsten, molybdenum, titanium, a compound thereof, or the like.

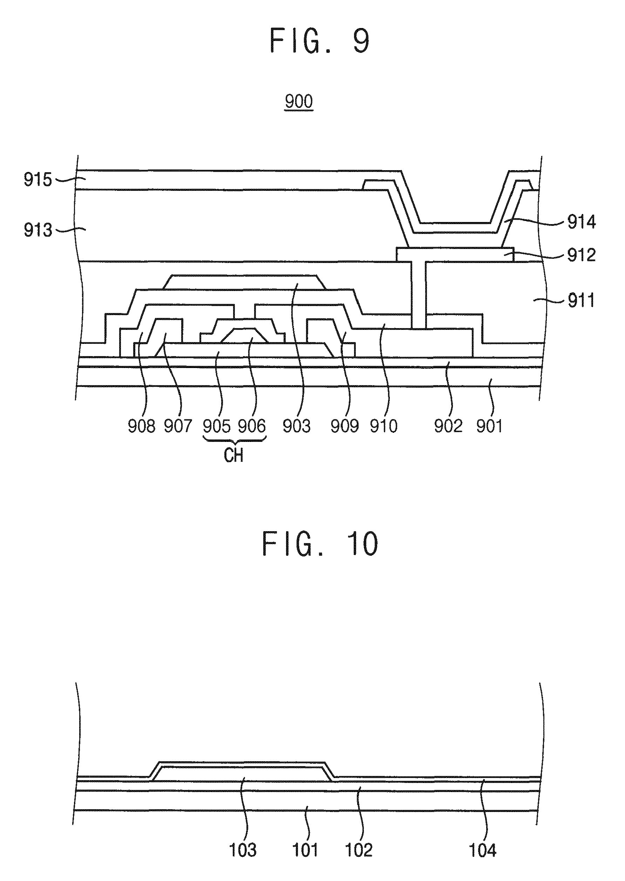

FIG. 9 is a cross-sectional view illustrating a display substrate according to an exemplary embodiment.

Referring to FIG. 9, a display substrate 900 includes an insulation substrate 901, a buffer layer 902, a channel layer CH, an etch-stop layer 907, a source electrode 908, a drain electrode 909, a first insulation layer 910, a gate electrode 903, a second insulation layer 911, a first electrode 912, a partition wall 913, a light-emitting layer 914, and a second electrode 915.

The display substrate 900 is substantially the same as the first substrate 500 illustrated in FIG. 5 except for further including the partition wall 913, the light-emitting layer 914, and the second electrode 915, while omitting the alignment layer AL1. Thus, any duplicated explanation may be omitted.

The channel layer CH may be disposed on the insulation substrate 901.

The channel layer CH may include a first channel layer 905 and a second channel layer 906.

A carrier concentration of the second channel layer 906 may be greater than a carrier concentration of the first channel layer 905. When the carrier concentration of the second channel layer 906 is greater than a carrier concentration of the first channel layer 905, an area in which an electron mobility is high is formed in the channel layer CH. Thus, a current level of the thin film transistor may be increased, resulting in an improvement in the display quality of a display device.

FIGS. 10 to 18 are cross-sectional views illustrating a method for manufacturing a display substrate according to an exemplary embodiment.

Referring to FIG. 10, a buffer layer 102 is formed on a first insulation layer 101. A gate electrode 103 is formed on the buffer layer 102. The first insulation layer 104 is formed to cover the gate electrode 103. The first insulation layer 104 may include an insulation material.

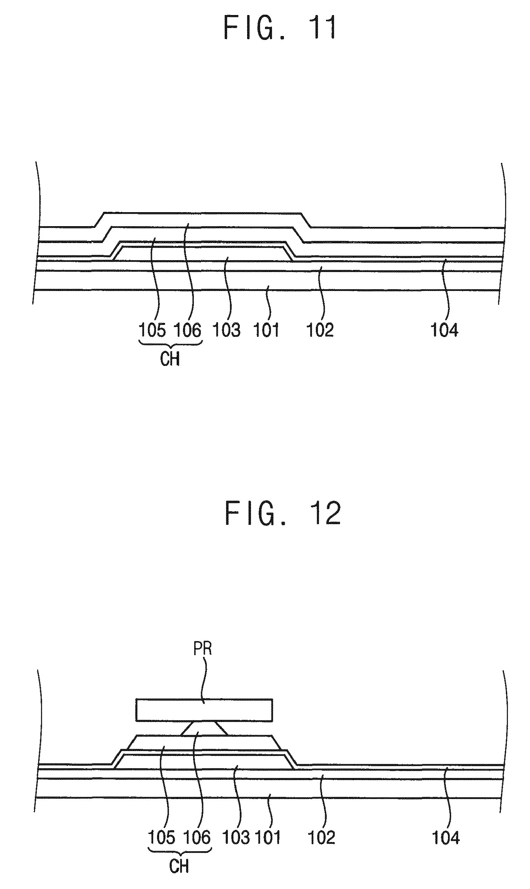

Referring to FIG. 11, a channel layer CH is formed on the first insulation layer 104. The channel layer CH includes a first channel layer 105 and a second channel layer 106. The first channel layer 105 and the second channel layer 106 may be consecutively deposited on the insulation layer 104. A carrier concentration of the second channel layer 106 may be greater than a carrier concentration of the first channel layer 105.

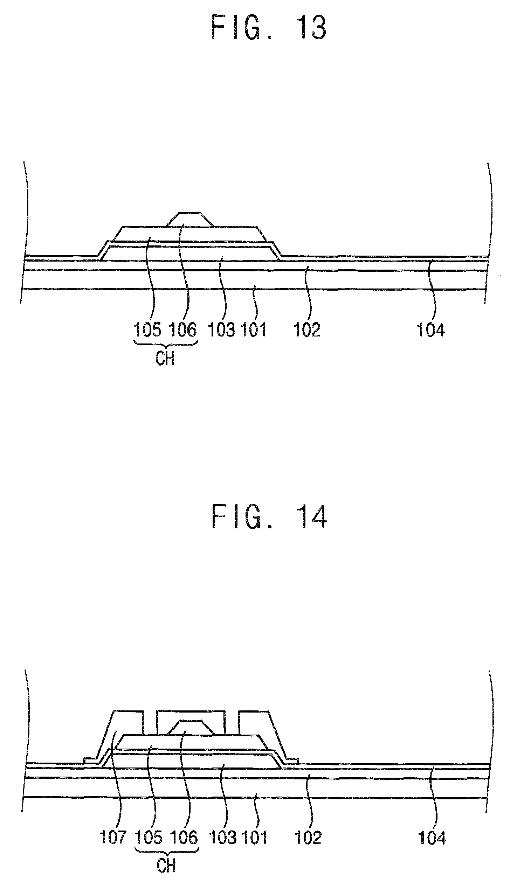

Referring to FIGS. 12 and 13, the channel layer CH is patterned by using a photoresist PR. The photoresist PR may include an organic material that is photosensitive. For example, the photoresist PR is provided on the channel layer CH, exposed to a light, and developed to form a pattern. The patterned photoresist PR is used as a mask for patterning the channel layer CH. The channel layer CH may be patterned by an etchant.

The first channel layer 105 and the second channel layer 106 may include different materials from each other. Thus, two different etchants may be used for patterning the channel layer CH. In another exemplary embodiment, a same etchant may be used for patterning the channel layer CH.

In an exemplary embodiment, the first channel layer 105 may include at least one of tin and aluminum. For example, the first channel layer 105 may include aluminum zinc oxide, indium zinc tin oxide, aluminum zinc tin oxide, or the like. The first channel layer 105 including tin or aluminum may have an etching resistance greater than that of the second channel layer 106. For example, when an amount of aluminum in the first channel layer 105 is increased, an etching resistance may be increased.

The second channel layer 106 may include a material having an etching resistance less than the first channel layer 105. For example, the second channel layer 106 may include an oxide based on indium or zinc. For example, the second channel layer 106 may include indium zinc oxide, aluminum zinc oxide, or the like.

For example, an etchant including hydrogen fluoride, ammonium fluoride, oxalic acid, or the like may be used for etching the first channel layer 105 including tin.

When an etching ratio of the second channel layer 106 is greater than an etching ratio of the first channel layer 105, when the first channel layer 105 and the second channel layer 106 are exposed to a same etchant, the second channel layer 106 may be more etched. Thus, as illustrated in FIG. 13, the second channel layer 106 smaller than the first channel layer 105 may be formed through a same patterning process without using an additional mask.

Referring to FIG. 14, an etch-stop layer 107 is formed to cover the channel layer CH. The etch-stop layer 107 may partially cover the first channel layer 105 and entirely cover the second channel layer 106. The etch-stop layer 107 may protect the channel layer CH in the process of forming a source electrode and a drain electrode.

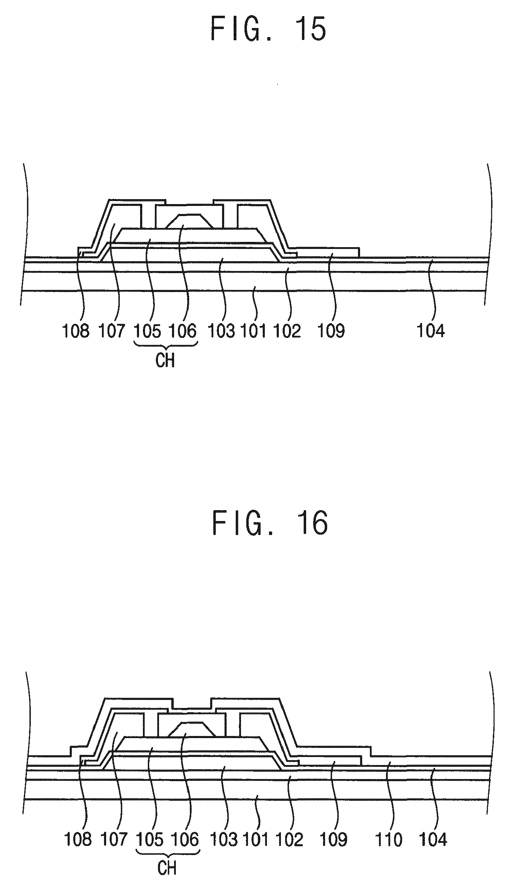

Referring to FIG. 15, a source electrode 108 and a drain electrode are formed to overlap the channel layer CH. The source electrode 108 is spaced apart from the drain electrode 109. The source electrode 108 and the drain electrode 109 may contact the first channel layer 105. The source electrode 108 and the drain electrode 109 may be formed from a same metal layer.

Referring to FIG. 16, a second insulation layer 110 is formed on the insulation substrate 101 including the source electrode 108 and the drain electrode 109. The second insulation layer 110 may include an inorganic material or an organic material. For example, the second insulation layer 110 may include silicon oxide, silicon nitride, or a polymer resin such as acryl resin.

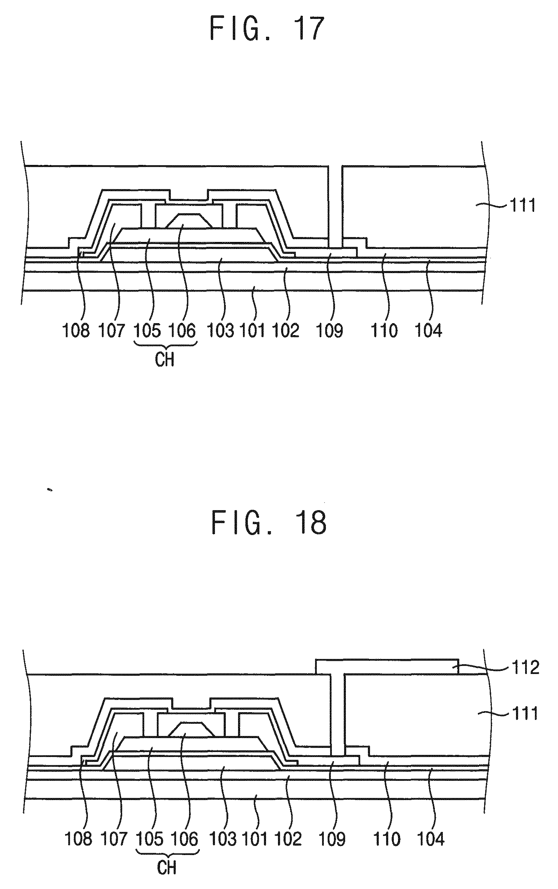

Referring to FIG. 17, a third insulation layer 111 is formed on the insulation substrate 101 including the second insulation layer 110. The third insulation layer 111 may include an inorganic material or an organic material and may have a substantially flat upper surface. For example, the third insulation layer 111 may include silicon oxide, silicon nitride, or a polymer resin such as acryl resin.

A contact hole is formed through the second insulation layer 110 and the third insulation layer 111 to expose the drain electrode 109.

Referring to FIG. 18, a first electrode 112 is formed on the insulation layer 101 including the second insulation layer 110 and the third insulation layer 111. The first electrode 112 may contact the drain electrode 109 through the contact hole of the second insulation layer 110 and the third insulation layer 111

According to an exemplary embodiment, a thin film transistor having a high current level may be formed, thereby resulting in an improvement in the display quality of a display device.

Furthermore, the first channel layer 105 and the second channel layer 106 having different sizes may be formed without using an additional mask.

As discussed, embodiments of the invention can provide a thin film transistor comprising: a gate electrode disposed over a substrate; a channel overlapping the gate electrode; a source electrode electrically connected to the channel; and a drain electrode electrically connected to the channel and spaced apart from the source electrode, wherein the channel comprises: a first channel layer contacting the source electrode and the drain electrode; and a second channel layer spaced apart from the source electrode and the drain electrode.

In some embodiments, the second channel layer may be disposed over the first channel layer. In some embodiments, the second channel layer may contact the first channel layer.

The first and second channel layers may be respectively provided with lower (or first) surfaces and upper (or second) surfaces that are parallel to the plane of the substrate, and side surfaces that connect the lower and upper surfaces. The side surfaces of the first channel layer and the second channel layer may be tapered (i.e. not normal to the substrate). In some embodiments, a taper angle of the first channel layer is greater than a taper angle of the second channel layer.

An exemplary embodiment may be employed in various electronic devices and various display devices including a liquid crystal device and an organic light-emitting display device.

Although certain exemplary embodiments and implementations have been described herein, other embodiments and modifications will be apparent from this description. Accordingly, the inventive concept is not limited to such embodiments, but rather to the broader scope of the presented claims and various obvious modifications and equivalent arrangements.

## Claims

1. A thin film transistor comprising:
a gate electrode disposed over a substrate;
a channel overlapping the gate electrode;
a source electrode electrically connected to the channel; and
a drain electrode electrically connected to the channel and spaced apart from the source electrode,
wherein the channel comprises:
a first channel layer contacting the source electrode and the drain electrode; and
a second channel layer disposed on the channel layer and spaced apart from the source electrode and the drain electrode.

2. The thin film transistor of claim 1, wherein the channel is disposed over the gate electrode.

3. The thin film transistor of claim 1 or 2, wherein the source electrode and the drain electrode contact at least a portion of an upper surface of the first channel layer.

4. The thin film transistor of claim 3, further comprising an etch-stop layer covering the channel,
wherein at least a portion of the source electrode and the drain electrode are disposed on the etch-stop layer.

5. The thin film transistor of any one of claims 2 to 4, wherein the source electrode and the drain electrode contact at least a portion of an upper surface and at least a portion of a side surface of the first channel layer.

6. The thin film transistor of claim 5, further comprising an insulation layer covering the channel, the source electrode, and the drain electrode.

7. The thin film transistor of claim 1 or 2, wherein the channel is disposed under the gate electrode.

8. The thin film transistor of claim 7, wherein the source electrode and the drain electrode contact at least a portion of an upper surface of the first channel layer.

9. The thin film transistor of claim 8, further comprising an etch-stop layer covering the channel,
wherein at least a portion of the source electrode and the drain electrode are disposed on the etch-stop layer.

10. The thin film transistor of any one of claims 7 to 9, wherein the source electrode and the drain electrode contact at least a portion of an upper surface and at least a portion of a side surface of the first channel layer.

11. The thin film transistor of any one of claims 1 to 10, wherein a carrier concentration of the second channel layer is greater than a carrier concentration of the first channel layer.

12. The thin film transistor of claim 11, wherein the first channel layer includes at least one selected from the group consisting of tin oxide and aluminum oxide, and the second channel layer includes at least one selected from the group consisting of indium oxide and zinc oxide.

13. The thin film transistor of any one of claims 1 to 12, wherein the first channel layer surrounds the second channel layer when considered in a plan view.

14. The thin film transistor of any one of claims 1 to 13, wherein side surfaces of the first channel layer and the second channel layer are tapered, and wherein a taper angle of the first channel layer is greater than a taper angle of the second channel layer.

15. A display device comprising:
a first substrate;
a thin film transistor of any one of claims 1 to 14 over the first substrate, wherein a pixel electrode is electrically connected to the drain electrode;
a second substrate facing the first substrate; and
a liquid crystal layer or a light emitting layer disposed between the first substrate and the second substrate.
